# FASCICULE DE BREVET EUROPEEN

(11) **EP 3 673 519 B1**
(45) Date de publication et mention de la délivrance du brevet: **03.11.2021**
(21) Numéro de dépôt: 18749798.7
(22) Date de dépôt: 03.08.2018
(51) Int. Cl.: H01L 35/32

(54) **GENERATEUR THERMOELECTRIQUE**
THERMOELEKTRISCHER GENERATOR
THERMOELECTRIC GENERATOR

(30) Priorité: 24.08.2017 FR 1757846
(43) Date de publication de la demande: 01.07.2020
(73) Titulaire: Centre National de la Recherche Scientifique, 75016 Paris (FR)
(72) Inventeur: GARDEN, Jean-Luc, 38130 Echirolles (FR); ANDRE, Emmanuel, 38240 Meylan (FR); MOIROUX, Gaël, 38450 Vif (FR)
(74) Mandataire: IPAZ
(86) Numéro de dépôt international: PCT/EP2018/071185
(87) Numéro de publication internationale: WO 2019/038066

(56) Documents cités:
- EP-A1- 3 086 379
- EP-A2- 1 976 034
- JP-A- H11 233 837
- JP-A- 2010 027 986

## Description

### Domaine

La présente demande concerne un générateur thermoélectrique, convertissant de l'énergie thermique en électricité.

### Exposé de l'art antérieur

Pour certaines applications de production d'électricité, on utilise un générateur thermoélectrique en contact avec une source de chaleur. La source de chaleur est typiquement un tuyau dans lequel circule un fluide chaud, par exemple plus chaud que l'air ambiant, un caloduc ou un doigt caloporteur métallique. La chaleur apportée par la source peut avoir diverses origines. Par exemple, cette chaleur peut provenir d'un élément de stockage de chaleur rempli le jour par le soleil et utilisé la nuit pour la production d'électricité. Cette chaleur peut aussi provenir, dans une installation industrielle, des pertes thermiques que l'on récupère pour la production d'électricité. Le document EP 3 086 379 A1 concerne un dispositif de récupération d'énergie thermoélectrique et un procédé de récupération d'énergie.

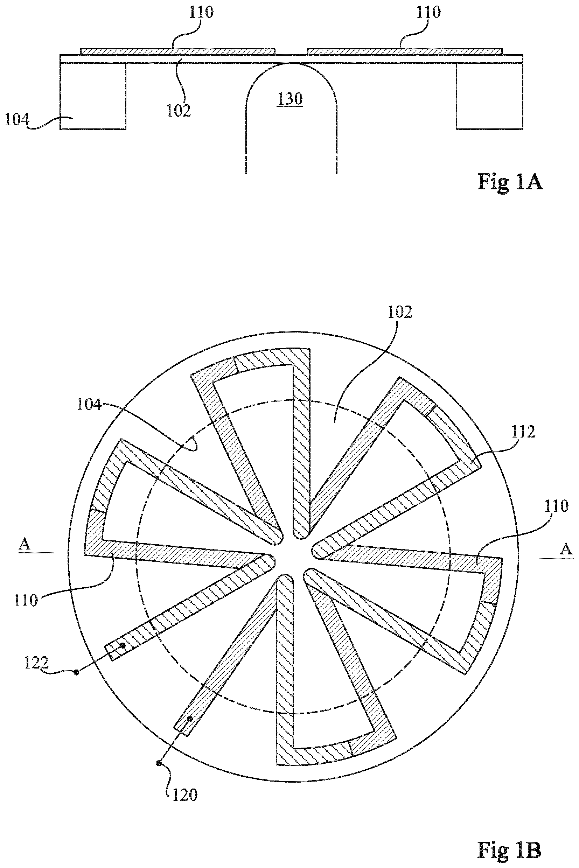

Les figures 1A et 1B sont respectivement une vue schématique en coupe et une vue schématique de dessus d'un exemple de générateur thermoélectrique, en contact avec une source de chaleur.

Une membrane 102 suspendue repose sur un cadre 104. Des pistes thermoélectriques de deux types différents 110, 112 reposent sur la membrane 102 (les pistes 112 sont visibles uniquement en figure 1B). Bien que 12 pistes soient représentées à titre d'exemple, il peut y avoir en pratique entre 2 et plus de 100 pistes. Les deux types de pistes sont, par exemple, du chromel et du constantan, du cuivre et du constantan, ou peuvent correspondre aux types de dopage N et P d'un semiconducteur, par exemple du silicium ou du tellure de bismuth, les deux matériaux constituant les éléments d'un couple thermoélectrique. Les pistes sont associées électriquement en série, et thermiquement en parallèle, les deux types de pistes étant alternés. Lorsque l'on parcourt l'association série, les extrémités en contact entre les pistes consécutives sont situées alternativement sur le cadre et sur une partie centrale de la membrane. Les extrémités de l'association série sont équipées de bornes de contact électrique 120 et 122.

Une source de chaleur 130, par exemple l'extrémité d'un doigt caloporteur, est en contact thermique et mécanique avec le centre de la membrane.

En fonctionnement, on maintient le cadre 104 à une température sensiblement égale à la température ambiante, par exemple en fixant le cadre sur un radiateur non représenté. Le centre de la membrane 102 est chauffé par la source 130 et porté à une température supérieure à celle du cadre. Une tension apparaît alors entre les bornes 120 et 122.

Diverses difficultés se posent pour mettre les parties centrales de la membrane en contact mécanique et thermique avec la source de chaleur. Il en résulte divers problèmes de mise en oeuvre, de rendement, et/ou de détérioration de la membrane et/ou des pistes.

### Résumé

L'invention concerne un générateur d'électricité selon la revendication indépendante 1. Ainsi, un mode de réalisation prévoit de pallier tout ou partie des inconvénients décrits ci-dessus.

Un mode de réalisation prévoit un générateur thermoélectrique particulièrement simple à mettre en contact mécanique et thermique avec une source de chaleur.

Un mode de réalisation prévoit un générateur thermoélectrique au rendement particulièrement élevé.

Un mode de réalisation prévoit un générateur thermoélectrique particulièrement robuste.

Un mode de réalisation prévoit un générateur d'électricité comprenant une membrane suspendue reposant sur un cadre, la membrane portant des pistes thermoélectriques de types alternés reliées en série et ayant chacune une extrémité sur le cadre et une extrémité sur une partie centrale de la membrane, dans lequel la membrane est déformable, les parties centrales de la membrane étant destinées à être en contact mécanique et thermique avec une source de chaleur.

Selon un mode de réalisation, la membrane est en un polyimide.

Selon un mode de réalisation, le polyimide est thermostable.

Selon un mode de réalisation, la membrane a une épaisseur comprise entre 10 et 100 µm.

Selon un mode de réalisation, la membrane comprend des fentes qui s'étendent entre les pistes à partir d'un point central de la membrane.

Selon un mode de réalisation, la membrane comprend un trou central.

Selon un mode de réalisation, les pistes sont plus larges vers les bords que vers le centre de la membrane, et, sur les parties suspendues de la membrane, les espaces entre pistes voisines correspondent à des bandes radiales de largeur inférieure à 0,5 mm.

Selon un mode de réalisation, les parties centrales de la membrane sont revêtues d'une couche thermiquement conductrice destinée à former ledit contact mécanique et thermique.

Selon un mode de réalisation, les pistes sont en un semiconducteur dopé et les types des pistes sont les types de dopage N et P.

Un mode de réalisation prévoit un ensemble de générateurs disposés en réseau, comprenant des générateurs ci-dessus reliés électriquement en série et/ou en parallèle.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B, décrites ci-dessus, sont respectivement une vue schématique en coupe et une vue schématique de dessus d'un générateur thermoélectrique ;
la figure 2 est une vue schématique en coupe d'un mode de réalisation d'un générateur thermoélectrique en contact avec une source de chaleur ;
la figure 3A est une vue schématique de dessus d'un autre mode de réalisation d'un générateur thermoélectrique ;
la figure 3B est une vue schématique en coupe du générateur de la figure 3A, en contact avec une source de chaleur ;
la figure 4A est une vue schématique de dessus d'un autre mode de réalisation d'un générateur thermoélectrique ;
la figure 4B est une vue schématique en coupe du générateur de la figure 4A, en contact avec une source de chaleur ; et
la figure 5 est une vue schématique de dessus d'un autre mode de réalisation d'un générateur thermoélectrique.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position relative, tels que le terme "dessus", il est fait référence à l'orientation de l'élément concerné dans les vues en coupe. Sauf précision contraire, l'expression "sensiblement" signifie à 10 % près, de préférence à 5 % près.

Dans les dispositifs connus du type décrit en préambule, la membrane 102 est typiquement à base de silicium, par exemple en oxyde de silicium ou en nitrure de silicium. Ces matériaux sont couramment utilisés car ils sont bien connus dans les procédés de microfabrication, et notamment dans les procédés de lithographie tels que celui utilisé pour réaliser les pistes thermoélectriques. On propose ici d'utiliser une membrane déformable, c'est-à-dire flexible et de préférence extensible, c'est-à-dire que la membrane est en un matériau ayant un allongement à la rupture (en anglais "Elongation at Break") supérieur à 20%, par exemple plus de 40 % voire plus de 70 % à 25°C, et par exemple de plus de 60 % à 300°C, voire plus de 80 % à 200°C. La membrane déformable est par exemple en un polyimide, de préférence en un polyimide thermostable tel qu'un polyimide aromatique.

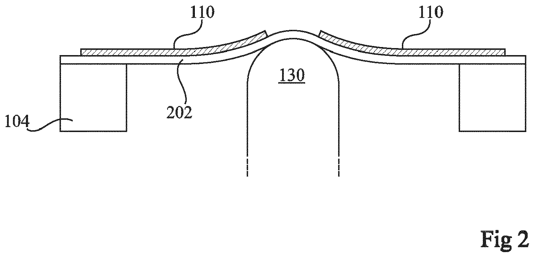

La figure 2 est une vue schématique en coupe d'un mode de réalisation d'un générateur thermoélectrique en contact avec une source de chaleur 130. Le générateur thermoélectrique de la figure 2 diffère du générateur thermoélectrique de la figure 1 en ce que la membrane 102 est remplacée par une membrane déformable 202. Les autres éléments sont identiques ou similaires et agencés de manière identique ou similaire.

A titre d'exemple, le cadre est circulaire de diamètre compris entre 1 et 2 cm. L'épaisseur de la membrane déformable 202 est par exemple comprise entre 10 et 100 µm.

Selon un avantage, du fait que la membrane 202 est déformable, elle épouse localement, dans la zone de contact, la forme de la source de chaleur 130. Le contact thermique ainsi obtenu entre la source 130 et la membrane 202 est particulièrement bon, et le générateur a alors un rendement particulièrement élevé.

Selon un autre avantage, le générateur est particulièrement robuste. En effet, la source de chaleur peut être amenée à se déplacer par rapport au générateur, en particulier selon la direction orthogonale à la membrane. Ceci peut se produire par exemple suite à des dilatations thermiques telles que celle de la source de chaleur, provoquant par exemple l'allongement de la source lorsqu'elle est chauffée. Du fait que la membrane peut se déformer, elle suit, dans la zone de contact, le déplacement de la source de chaleur, sans que ceci n'entraine de rupture de la membrane.

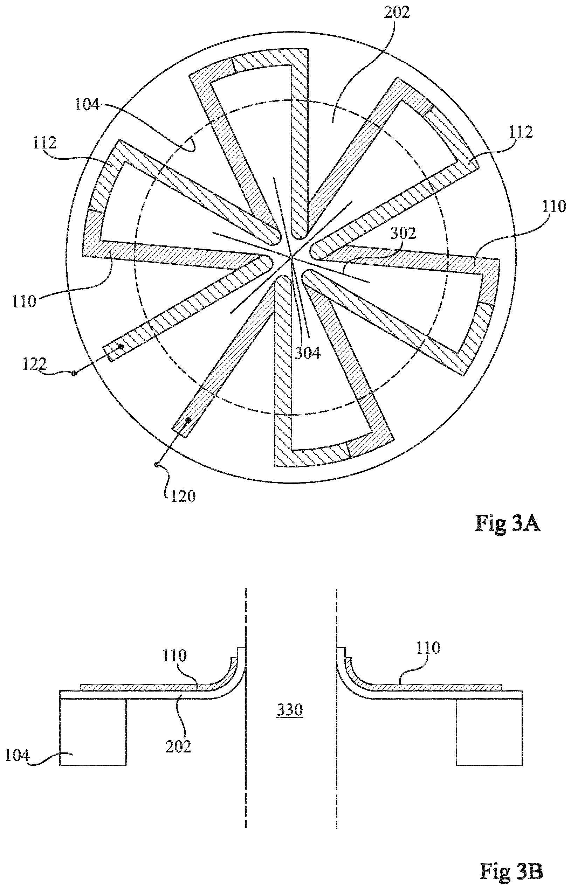

La figure 3A est une vue schématique de dessus d'un autre mode de réalisation d'un générateur thermoélectrique. Le générateur thermoélectrique de la figure 3A diffère de celui de la figure 2 en ce que la membrane déformable 202 comprend des fentes 302. Les fentes 302 traversent l'épaisseur de la membrane et s'étendent entre les pistes à partir du centre de la membrane. A titre d'exemple, le cadre est circulaire et les fentes sont régulièrement réparties. Les fentes sont par exemple radiales à partir d'un point central 304 de la membrane. A titre d'exemple, les fentes 132 ne concernent que les parties centrales de la membrane, c'est-à-dire qu'elles n'atteignent pas le cadre 104.

La figure 3B est une vue schématique en coupe du générateur thermoélectrique de la figure 3A en contact avec une source de chaleur. La source de chaleur 330 est ici un cylindre, par exemple une portion d'un tuyau, ou une structure conductrice thermiquement telle qu'une tige métallique ou un caloduc.

Pour réaliser le contact thermique, on prend le dispositif par le cadre, et on appuie le centre de la membrane, de préférence la face opposée aux pistes, sur l'extrémité (non représentée) de la source 330. Du fait que la membrane 202 est flexible, les parties de la membrane situées entre les fentes 302 se courbent et l'extrémité de la source 330 passe au travers de la membrane. Les parties centrales de la membrane se retrouvent en appui sur la paroi extérieure de la source 330.

On a ainsi obtenu de manière particulièrement simple un contact thermique entre les parties centrales de la membrane et une source de chaleur de forme cylindrique.

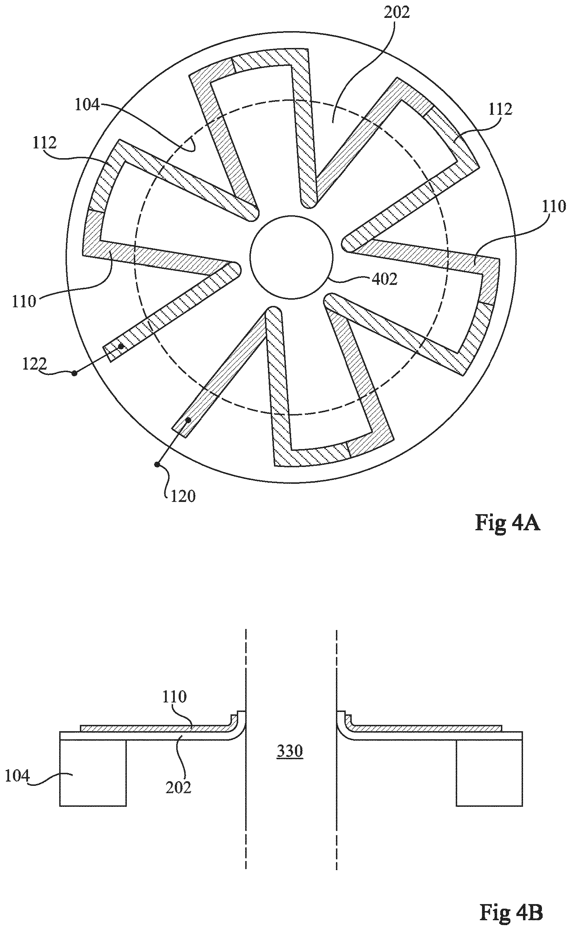

La figure 4A est une vue schématique de dessus d'un autre mode de réalisation d'un générateur thermoélectrique. Le générateur de la figure 4A diffère de celui de la figure 2A en ce que la membrane déformable 202 présente un trou central 402, par exemple un trou circulaire.

La figure 4B est une vue schématique en coupe du générateur thermoélectrique de la figure 4A, en contact avec une source de chaleur 330, par exemple cylindrique.

Avant mise en place, le trou 402 a un diamètre légèrement inférieur, par exemple compris entre 2 et 20 %, à celui de la source 330. Pour la mise en place, on procède de la manière décrite ci-dessus en relation avec les figures 3A et 3B, ce qui déforme la membrane autour du trou et provoque le passage de l'extrémité de la source à travers la membrane. On obtient ainsi de manière particulièrement simple un bon contact thermique entre la source 330 et les parties centrales de la membrane 202.

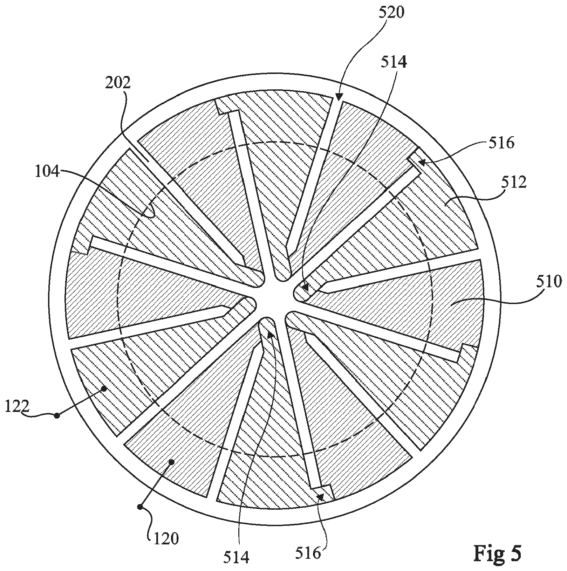

La figure 5 est une vue schématique de dessus d'un autre mode de réalisation d'un générateur thermoélectrique. Le générateur thermoélectrique de la figure 5 diffère de celui de la figure 2 en ce que les pistes thermoélectriques 110 et 112 sont remplacées respectivement par des pistes thermoélectriques 510 et 512. De même que les pistes thermoélectriques 110 et 112 du générateur de la figure 2, les pistes thermoélectriques 510 et 512 sont reliées électriquement en série et thermiquement en parallèle et sont de deux types différents alternés. De même que pour les pistes 110 et 112 de la figure 2, lorsque l'on parcourt l'association série de la borne 120 à la borne 122, les contacts entre extrémités de pistes sont successivement sur une partie centrale de la membrane (contact 514) et sur le cadre (contact 516) .

Les pistes 510 et 512 sont plus larges près du cadre 104 que vers le centre de la membrane 202. Les espaces 520 entre pistes voisines ont en vue de dessus et en dehors de l'extrémité des pistes, la forme de fines bandes rectilignes, par exemple des bandes de largeur inférieure à 0,5 mm, par exemple comprise entre 10 µm et 0,5 mm, de préférence inférieure à 0,1 mm. Les pistes 510 et 512 couvrent ainsi la plus grande surface possible de partie suspendue de la membrane. Ceci permet de réduire la résistance électrique des pistes pour une épaisseur donnée, et donc permet d'augmenter d'autant le rendement de conversion. On peut ainsi prévoir des pistes d'épaisseur réduite, par exemple inférieure à 5 µm, par exemple comprise entre 0,1 et 5 µm. Du fait que les pistes 510 et 512 sont d'épaisseur réduite, elles sont particulièrement flexibles.

Les pistes thermoélectriques (110, 112 ; 510, 512) décrites dans les différents modes de réalisation de la présente invention sont issues d'un procédé de dépôt connu dans l'art antérieur. Un tel procédé peut être un procédé de couches minces, tel que l'évaporation sous vide ou la pulvérisation assistée par magnétron, ou un procédé de dépôt électrolytique. Un traitement de la surface, tel que le traitement par plasma oxygène ou le dépôt d'une sous-couche d'adhérence, peut être appliqué sur la membrane, pour renforcer l'adhérence des pistes sur la membrane.

Des modes de réalisation particuliers ont été décrits. En particulier, dans les modes de réalisation décrits, on peut prévoir une couche thermiquement conductrice, par exemple en cuivre, en aluminium ou en or, recouvrant les parties centrales de la membrane. Cette couche conductrice est disposée de préférence sur la face de la membrane opposée aux pistes afin d'être isolée électriquement des pistes par la membrane. Cette couche conductrice peut aussi être disposée sur un isolant recouvrant les pistes. Dans les modes de réalisation des figures 3A et 4A, cette couche conductrice est traversée respectivement par les fentes 302 et/ou par le trou 402 sur toute son épaisseur. Lorsque que le générateur et la source de chaleur sont en place, cette couche conductrice est en contact mécanique et thermique avec la source de chaleur. En fonctionnement, cette couche permet de répartir la chaleur dans les parties centrales de la membrane. Le contact thermique entre la source de chaleur et les pistes est alors particulièrement bon, et le rendement du générateur est particulièrement élevé.

En outre, bien que le cadre 104 représenté ci-dessus soit circulaire, le cadre peut avoir toute autre forme, par exemple carrée, rectangulaire ou hexagonale.

Bien que le trou 402 du générateur de la figure 4A soit circulaire, le trou 402 peut avoir toute forme adaptée, en fonction de la forme de la source de chaleur, pour réaliser un contact thermique avec la source de chaleur.

Par ailleurs, on peut prévoir un ensemble de générateurs thermoélectriques selon les modes de réalisation décrits ci-dessus. Les générateurs sont disposés en réseau, par exemple en matrice. Les générateurs sont reliés en série et/ou en parallèle. On obtient ainsi une puissance électrique élevée. Les divers cadres des divers générateurs peuvent former un support unique comprenant une ouverture sous chaque membrane.

Divers modes de réalisation avec diverses variantes ont été décrits ci-dessus. En particulier, des fentes telles que les fentes 302 du générateur de la figure 3A peuvent être prévues dans le générateur de la figure 4A, les fentes s'étendant entre les pistes à partir du trou 402. Les fentes 302 du générateur de la figure 3A et/ou le trou 402 du générateur de la figure 4A peuvent être prévus dans le générateur de la figure 5.

En outre, on peut réaliser avec le générateur à trou central 402 de la figure 4A un contact thermique avec l'extrémité d'une source de chaleur 130, tel que le contact thermique décrit en relation avec la figure 2, le trou central 402 ayant alors pour rôle de rendre facilement déformables les parties centrales de la membrane.

## Revendications

1. Générateur d'électricité comprenant une membrane (202) suspendue reposant sur un cadre (104), la membrane portant des pistes thermoélectriques (110, 112 ; 510, 512) de types alternés reliées en série et ayant chacune une extrémité sur le cadre et une extrémité sur une partie centrale de la membrane, **caractérisé en ce que** la membrane est déformable, les parties centrales de la membrane étant destinées à être en contact mécanique et thermique avec une source de chaleur (130, 330).

2. Générateur selon la revendication 1, dans lequel la membrane (202) est en un polyimide.

3. Générateur selon la revendication 2, dans lequel le polyimide est thermostable.

4. Générateur selon l'une quelconque des revendications 1 à 3, dans lequel un traitement de la surface est appliqué sur la membrane.

5. Générateur selon l'une quelconque des revendications 1 à 4, dans lequel la membrane (202) a une épaisseur comprise entre 10 et 100 µm.

6. Générateur selon l'une quelconque des revendications 1 à 5, dans lequel la membrane (202) comprend des fentes (302) qui s'étendent entre les pistes à partir d'un point central (304) de la membrane.

7. Générateur selon l'une quelconque des revendications 1 à 6, dans lequel la membrane (202) comprend un trou central (402).

8. Générateur selon l'une quelconque des revendications 1 à 7, dans lequel les pistes (510, 512) sont plus larges vers les bords que vers le centre de la membrane, et, sur les parties suspendues de la membrane, les espaces (520) entre pistes voisines correspondent à des bandes radiales de largeur inférieure à 0,5 mm.

9. Générateur selon l'une quelconque des revendications 1 à 8, dans lequel les parties centrales de la membrane sont revêtues d'une couche thermiquement conductrice destinée à former ledit contact mécanique et thermique.

10. Générateur selon l'une quelconque des revendications 1 à 9, dans lequel les pistes (110, 112 ; 510, 512) sont en un semiconducteur dopé et les types des pistes sont les types de dopage N et P.

11. Ensemble de générateurs disposés en réseau, comprenant des générateurs selon l'une quelconque des revendications 1 à 10 reliés électriquement en série et/ou en parallèle.

## Patentansprüche

1. Elektrizitätsgenerator, umfassend eine auf einem Rahmen (104) abgestützte, aufgehängte Membran (202), wobei die Membran thermoelektrische Bahnen (110, 112; 510, 512) abwechselnden Typs trägt, die in Reihe geschaltet sind und jeweils ein Ende am Rahmen und ein Ende an einem mittleren Abschnitt der Membran aufweisen, **dadurch gekennzeichnet, dass** die Membran verformbar ist, wobei die mittleren Abschnitte der Membran dazu vorgesehen sind, in mechanischem und thermischem Kontakt mit einer Wärmequelle (130, 330) zu stehen.

2. Generator nach Anspruch 1, wobei die Membran (202) aus einem Polyimid gebildet ist.

3. Generator nach Anspruch 2, wobei das Polyimid thermostabil ist.

4. Generator nach einem der Ansprüche 1 bis 3, wobei eine Oberflächenbehandlung der Membran angewendet wurde.

5. Generator nach einem der Ansprüche 1 bis 4, wobei die Membran (202) eine Dicke im Bereich von 10 bis 100 µm besitzt.

6. Generator nach einem der Ansprüche 1 bis 5, wobei die Membran (202) Schlitze (302) aufweist, die sich ausgehend von einer mittleren Stelle (304) der Membran zwischen den Bahnen erstrecken.

7. Generator nach einem der Ansprüche 1 bis 6, wobei die Membran (202) eine mittlere Öffnung (402) aufweist.

8. Generator nach einem der Ansprüche 1 bis 7, wobei die Bahnen (510, 512) zu den Rändern hin breiter als zur Mitte der Membran hin sind, und an den aufgehängten Abschnitten der Membran die Lücken (520) zwischen benachbarten Bahnen radialen Streifen mit einer Breite von weniger als 0,5 mm entsprechen.

9. Generator nach einem der Ansprüche 1 bis 8, wobei die mittleren Abschnitte der Membran mit einer wärmeleitenden Schicht beschichtet sind, die zur Herstellung des mechanischen und thermischen Kontakts dient.

10. Generator nach einem der Ansprüche 1 bis 9, wobei die Bahnen (110, 112; 510, 512) aus einem dotierten Halbleiter gebildet sind und die Typen der Bahnen N- und P-Dotierungstypen sind.

11. Anordnung von in einem System angeordneten Generatoren, umfassend Generatoren nach einem der Ansprüche 1 bis 10, die elektrisch in Reihe und/oder parallel geschaltet sind.

## Claims

1. Electricity generator comprising a suspended membrane (202) resting on a frame (104), the membrane having thermoelectric tracks (110, 112; 510, 512) of alternate types connected in series and each having one end on the frame and one end on a central part of the membrane, **characterized in that** the membrane is deformable, the central parts of the membrane being intended to be in mechanical and thermal contact with a heat source (130, 330).

2. Generator according to claim 1, in which the membrane (202) is made from a polyimide.

3. Generator according to claim 2, in which the polyimide is thermostable.

4. Generator according to any one of claims 1 to 3, in which a treatment of the surface is applied to the membrane.

5. Generator according to any one of claims 1 to 4, in which the membrane (202) has a thickness comprised between 10 and 100 µm.

6. Generator according to any one of claims 1 to 5, in which the membrane (202) comprises slits (302) which extend between the tracks from a central point (304) of the membrane.

7. Generator according to any one of claims 1 to 6, in which the membrane (202) comprises a central hole (402).

8. Generator according to any one of claims 1 to 7, in which the tracks (510, 512) are wider towards the edges than towards the centre of the membrane and, on the suspended parts of the membrane, the spaces (520) between adjacent tracks correspond to radial strips having a width less than 0.5 mm.

9. Generator according to any one of claims 1 to 8, in which the central parts of the membrane are coated with a thermally conductive layer intended to form said mechanical and thermal contact.

10. Generator according to any one of claims 1 to 9, in which the tracks (110, 112; 510, 512) are made from a doped semiconductor and the types of tracks are the N and P-doping types.

11. Group of generators arranged in an array, comprising generators according to any one of claims 1 to 10, electrically connected in series and/or in parallel.
